# FASCICULE DE BREVET EUROPEEN

(11) **EP 1 437 834 B1**
(45) Date de publication et mention de la délivrance du brevet: **06.09.2006**
(21) Numéro de dépôt: 03290066.4
(22) Date de dépôt: 10.01.2003
(51) Int. Cl.: H03M 3/02

(54) **Dispositif d'amplification de puissance, notamment à dynamique d'entrée réduite, en particulier pour un téléphone mobile cellulaire**
Vorrichtung zur Leistungsverstärkung, insbesondere mit reduziertem Eingangsdynamik, für ein Mobiltelefon
Power amplifier circuit, in particular with low input dynamic range, for cellular mobile phone

(43) Date de publication de la demande: 14.07.2004
(73) Titulaire: STMicroelectronics N.V., 1077 XX Amsterdam (NL); STMicroelectronics S.r.l., 20041 Agrate Brianza (Milano) (IT)
(72) Inventeur: Cerisier, Patrick, 74350 Copponex (FR); Panigada, Andrea, 27100 Pavia (PV) (IT)
(74) Mandataire: Casalonga, Axel

(56) Documents cités:
- WO-A-01/03312
- US-A- 5 039 989

## Description

L'invention concerne l'amplification de puissance, notamment mais non exclusivement celle utilisée dans les systèmes de communication sans fil, en particulier au sein des téléphones mobiles cellulaires.

Dans un système de communication sans fil, une station de base communique avec une pluralité de terminaux distants, tels que des téléphones mobiles cellulaires. Les accès multiples par division de fréquence (FDMA : « Frequency-Division Multiple Access » en langue anglaise) et les accès multiples par division temporelle (TDMA : « Time Division Multiple Access » en langue anglaise) sont les schémas d'accès multiples traditionnels pour délivrer des services simultanés à un certain nombre de terminaux. L'idée de base sous-jacente aux systèmes FDMA et TDMA consiste à partager la ressource disponible, respectivement en plusieurs fréquences ou en plusieurs intervalles temporels, de telle sorte que plusieurs terminaux peuvent fonctionner simultanément sans provoquer d'interférence.

A l'opposé de ces schémas utilisant une division de fréquence ou une division temporelle, les schémas CDMA permettent aux utilisateurs multiples de partager une fréquence commune et un tel canal temporel commun en utilisant une modulation codée.

Plus précisément, comme il est bien connu par l'homme du métier, un code d'embrouillage (« scrambling code » en langue anglaise) est associé à chaque station de base et permet de distinguer une station de base d'une autre. En outre, un code orthogonal, connu par l'homme du métier sous la dénomination de « Code OVSF », est alloué à chaque terminal distant (comme par exemple un téléphone mobile cellulaire). Tous les codes OVSF sont orthogonaux entre eux, ce qui permet de distinguer un terminal distant d'un autre.

Avant d'émettre un signal sur le canal de transmission à destination d'un terminal distant, le signal a été embrouillé et étalé (« spread » en langue anglaise) par la section de base en utilisant le code d'embrouillage de la station de base et le code OVSF du terminal distant.

Dans les systèmes CDMA, on peut encore distinguer ceux qui utilisant une fréquence distincte pour l'émission et la réception (système CDMA-FDD) et ceux qui utilisent une fréquence commune pour l'émission et la réception, mais des domaines temporels distincts pour l'émission et la réception (système CDMA-TDD).

Les terminaux, tels que les téléphones mobiles cellulaires, de troisième génération doivent être compatibles avec la norme UMTS, c'est-à-dire qu'ils doivent être capables de fonctionner sous différentes normes de transmissions sans fil. Ainsi, ils devront être capables de fonctionner dans un système du type FDMA/TDMA, selon par exemple la norme de transmission GSM ou GPRS, ou encore dans des systèmes de communication du type CDMA-FDD ou CDMA-TDD, en utilisant par exemple les normes de transmission UTRA-FDD ou UTRA-TDD ou IS-95.

L'invention s'applique ainsi notamment à tous les terminaux ou composants de systèmes de communication sans fil, par exemple les téléphones mobiles cellulaires, quelle que soit la norme de transmission utilisée, que celle-ci prévoit une modulation à enveloppe constante (systèmes GSM et DCS, par exemple) ou variable (systèmes du type CDMA), bien que l'invention soit particulièrement avantageuse pour les systèmes à modulation à enveloppe variable.

La chaîne d'émission radiofréquence d'un composant d'un système de communication sans fil, par exemple un téléphone mobile cellulaire, comporte un amplificateur de puissance destiné à amplifier le signal à un niveau suffisant pour pouvoir le transmettre. Dans les systèmes fonctionnant selon la norme CDMA, qui présentent une modulation à enveloppe variable, on utilise une chaîne d'émission linéaire qui permet de retransmettre sans distorsion l'amplitude du signal.

Une solution pour réaliser les moyens d'amplification de puissance de la chaîne d'émission consiste à utiliser des moyens d'amplification du type delta-sigma. Un exemple d'une telle architecture est par exemple décrit dans le brevet américain n° 5 777 512.

Des moyens d'amplification du type delta-sigma présentent intrinsèquement l'avantage d'être plus compétitifs en terme d'efficacité que des moyens d'amplification linéaires classiques.

De tels moyens d'amplification du type delta sigma comportent des réseaux sélecteurs de fréquences qui permettent d'ajuster la position des zéros de la fonction de transfert de bruit, c'est-à-dire d'ajuster les fréquences auxquelles le bruit de quantification est en théorie éliminé. Et, traditionnellement, ces zéros sont placés dans la bande utile de transmission dans laquelle le signal se situe, de façon à respecter le rapport signal/bruit requis par la norme de transmission utilisée.

Il est par ailleurs nécessaire de respecter des gabarits de bruit définis par les normes de transmission, et prévoyant qu'en dehors de la bande utile du signal, le bruit ne doit pas dépasser un certain niveau d'énergie, afin de ne pas perturber d'autres émissions/réceptions qui utiliseraient des normes de transmission différentes.

Et ce bruit résulte en particulier du bruit de quantification produit par l'amplificateur delta sigma, et du bruit parasite entachant le signal d'entrée de l'amplificateur.

Puisque la majeure partie du bruit de quantification est repoussée hors de la bande utile du signal, il est alors nécessaire de prévoir en sortie des moyens d'amplification de type delta-sigma, un ou plusieurs filtres post-amplificateurs dont la fonction consiste notamment à éliminer le bruit de quantification situé en dehors de la bande de signal utile. Un exemple d'une telle architecture est décrit, par exemple, dans le brevet US 5 039 989.

Par ailleurs on prévoit des contraintes de filtrage sur les éléments de la chaîne d'émission disposés en amont de l'amplificateur delta sigma, afin de limiter le bruit parasite entachant le signal d'entrée de l'amplificateur.

En outre la contrainte de dynamique au niveau de l'antenne d'émission est forte. Il en résulte alors une contrainte sur le niveau de signal en sortie des moyens d'amplification de puissance (à titre indicatif, le niveau maximum requis en sortie de l'amplificateur dans la norme WCDMA est de 27 dBm), et par conséquent sur le niveau de signal en entrée de l'amplificateur. Ainsi actuellement, avec un gain typique de l'amplificateur de 25 dB, le niveau maximum du signal en entrée de l'amplificateur doit être de 2 dBm dans la norme WCDMA, ce qui a un impact non négligeable sur la consommation.

Ainsi non seulement la dynamique d'entrée des moyens d'amplification de puissance doit être élevée, mais la puissance de sortie du mélangeur disposé en amont du dispositif d'amplification de puissance, doit être également importante, ce qui est aussi pénalisant en terme de consommation.

L'invention vise à apporter une solution à ces problèmes.

L'invention a pour but de diminuer la dynamique d'entrée des moyens d'amplification de puissance, et de réduire la puissance de sortie du mélangeur disposé en amont du dispositif d'amplification de puissance.

L'invention a également pour but d'améliorer le filtrage du signal d'entrée en dehors de la bande utile, et par conséquent de relâcher les contraintes de filtrage sur les éléments de la chaîne d'émission disposés en amont des moyens d'amplification.

L'invention a encore pour but d'ajuster le gain de l'amplificateur, en particulier dans la bande de transmission utile, et ce sans dégrader le rapport signal/bruit.

L'invention propose donc un dispositif d'amplification de puissance, comportant une entrée pour recevoir un signal ayant une bande fréquentielle utile, et des moyens d'amplification de puissance du type delta-sigma.

Selon une caractéristique générale de l'invention, les moyens d'amplification de puissance du type delta-sigma présentent un ordre global supérieur ou égal à un, et le dispositif comporte au moins deux amplificateurs de signal (gains de signal) connectés entre ladite entrée et les moyens d'amplification de puissance, les valeurs relatives de ces gains de signal étant ajustées de façon à localiser les zéros de la fonction de transfert de signal en dehors de ladite bande fréquentielle utile.

Ce nombre d'amplificateurs de signal (gains de signal), peut être égal à l'ordre global des moyens d'amplification de puissance, augmenté d'une unité.

En d'autres termes, l'invention résout le problème de la diminution de la dynamique d'entrée et du filtrage du bruit entachant le signal d'entrée hors de la bande utile du signal en modifiant l'architecture classique des moyens d'amplification du type delta-sigma.

Plus précisément la présence d'au moins deux gains de signal permet d'ajuster les zéros de la fonction de transfert polynomial du signal. Puisque les zéros de la fonction de transfert du signal sont alors différents des zéros de la fonction de transfert du bruit, on peut également ajuster par la présence de ces gains de signal, des valeurs de fréquence hors de la bande utile pour lesquelles on souhaite éliminer du bruit sur le signal d'entrée. On réalise ainsi par construction même des moyens d'amplification de puissance, un filtrage du signal d'entrée hors de la bande utile, ce qui permet de relâcher les contraintes de filtrage sur les éléments situés en amont du dispositif d'amplification de puissance selon l'invention.

Par ailleurs, puisque le ou les gains de signal agissent uniquement sur le signal d'entrée, on réduit ainsi la dynamique d'entrée des moyens d'amplification, et par conséquent la puissance de sortie du mélangeur situé en amont.

L'invention permet en outre de fixer le gain total des moyens d'amplification de puissance en jouant sur la valeur des gains de signal.

Il est également possible de prévoir des gains de signal programmables.

Le dispositif d'amplification de puissance selon l'invention est avantageusement réalisé sous la forme d'un circuit intégré.

L'invention propose également un composant d'un système de communication sans fil, comportant un dispositif d'amplification de puissance tel que défini ci-avant.

Ce composant peut être par exemple un téléphone mobile cellulaire, ou bien une station de base.

D'autres avantages et caractéristiques de l'invention apparaîtront à l'examen de la description détaillée de modes de réalisation, nullement limitatifs, et des dessins annexés sur lesquels :
- la figure 1 illustre de façon schématique la structure d'un téléphone mobile cellulaire selon l'invention,
- et,
- la figure 2 illustre de façon schématique un mode de réalisation d'un dispositif d'amplification de puissance selon l'invention.

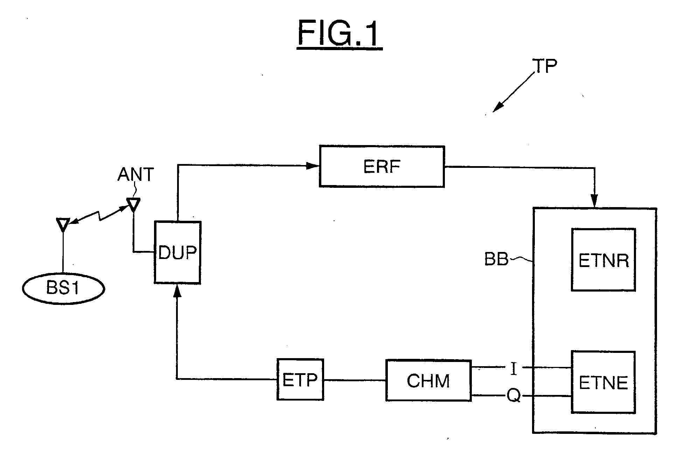

Sur la figure 1, la référence TP désigne un terminal distant, tel qu'un téléphone mobile cellulaire, qui est en communication avec une station de base BS1, par exemple selon un schéma de communication du type CDMA-FDD (par exemple norme UTRA-FDD).

Le téléphone mobile cellulaire comprend, de façon classique, un étage analogique radiofréquence ERF connecté à une antenne ANT par l'intermédiaire d'un duplexeur DUP, pour recevoir un signal d'entrée.

Classiquement, l'étage ERF comprend un amplificateur faible bruit et deux voies de traitement comportant des mélangeurs, des filtres et amplificateurs classiques. Les deux mélangeurs reçoivent respectivement de la part d'une boucle à verrouillage de phase deux signaux présentant mutuellement une différence de phase de 90°. Après transposition de fréquence dans les mélangeurs, les deux voies de traitement définissent respectivement deux flux I (flux direct) et Q (flux en quadrature) selon une dénomination bien connue de l'homme du métier.

Après conversion numérique dans des convertisseurs analogiques/numériques CAN, les deux flux I et Q sont délivrés à un étage de traitement de réception ETNR.

Cet étage de traitement ETNR comprend, de façon classique, un récepteur, communément désigné par l'homme du métier "récepteur Rake", suivi par des moyens classiques de démodulation qui effectuent la démodulation de la constellation délivrée par le récepteur Rake.

L'étage de traitement ETNR comprend également de façon classique un décodeur de source qui effectue un décodage de source bien connu par l'homme du métier.

Le bloc de traitement en bande de base BB comporte, outre l'étage de traitement ETNR, un étage de traitement d'émission ETNE qui effectue, de façon classique, notamment les traitements de codage de source, d'étalement des symboles, de modulation, pour délivrer les deux flux I et Q à une chaîne d'émission CHM de structure classique.

Cette chaîne d'émission CHM comporte notamment en tête, des convertisseurs numériques / analogiques, ainsi que des mélangeurs permettant d'effectuer une transposition de fréquence à la fréquence d'émission. Là encore, les signaux de transposition sont délivrés par une boucle à verrouillage de phase (non représentée ici à des fins de simplification) contrôlée également par des moyens de contrôle automatique de fréquence incorporés dans l'étage ETNE.

La chaîne CHM est classiquement suivie d'un étage amplificateur de puissance ETP connecté à l'antenne par le duplexeur DUP.

Le groupe de normalisation 3GPP définit dans la spécification TS25 101 des valeurs de niveau de bruit à ne pas dépasser au niveau du connecteur d'antenne.

Le dispositif d'amplification de puissance selon l'invention va alors être architecturé de façon notamment à satisfaire aux exigences du rapport signal/bruit dans la bande utile du signal, à intoduire un filtrage du bruit entachant le signal d'entrée, tout en présentant une dynamique d'entrée réduite.

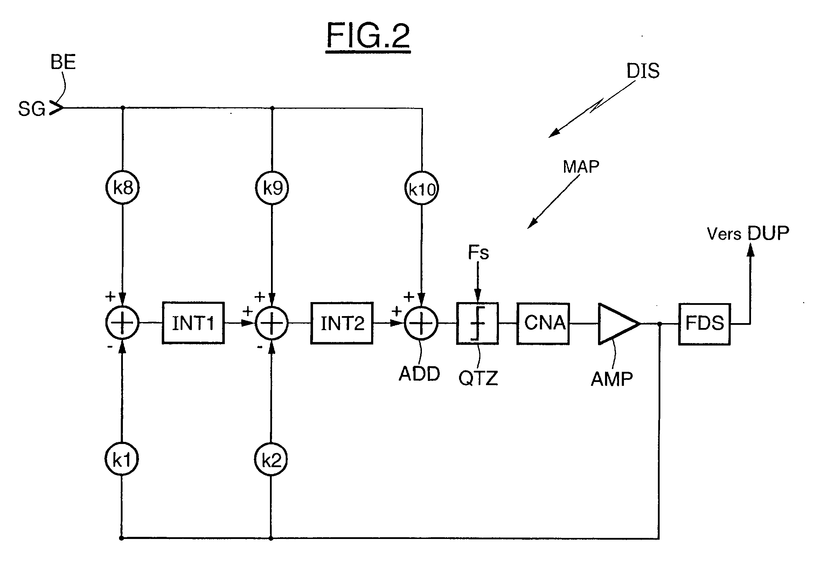

Plus précisément, comme illustré sur la figure 2, le dispositif d'amplification de puissance DIS comporte une borne d'entrée BE recevant le signal SG à amplifier, suivie des moyens d'amplification de puissance MAP du type delta-sigma.

Le signal SG provient ici d'un mélangeur ayant transposé le signal SG dans le domaine radiofréquence.

D'une façon générale, il est prévu au moins deux gains de signal (amplificateurs de signal) disposé entre la borne d'entrée BE et les moyens d'amplification de puissance MAP. En l'espèce, il est prévu 3 gains de signal k8-k10, respectivement connectés entre la borne d'entrée BE et des additionneurs/soustracteurs disposés en amont de moyens d'intégration, formé ici de réseaux sélecteurs de fréquences, INT1-INT2 ainsi qu'entre la borne d'entrée BE et un additionneur supplémentaire ADD disposé entre le réseau sélecteur de fréquence INT2 et un moyen de quantification QTZ.

Le signal délivré à la sortie de l'additionneur ADD est ensuite quantifié sur un bit dans le moyen de quantification QTZ.

Le signal, de forme d'onde carrée, délivré par le moyen de quantification QTZ est ensuite amplifié, après conversion numérique analogique CNA, dans un amplificateur de puissance AMP fonctionnant ici en classe E (c'est-à-dire sur des signaux carrés).

La sortie de l'amplificateur est rebouclée sur les entrées des additionneurs/soustracteurs par deux gains continus respectivement référencés dans cet exemple k1 et k2.

La sortie de l'amplificateur AMP est également reliée à l'entrée d'un filtre post-amplificateur FDS, qui est un filtre passe-bande, dont la sortie est reliée au duplexeur DUP.

Les moyens d'amplification de puissance MAP du type delta-sigma, ont ici, pour des raisons de simplification de la figure 2, un ordre global égal à 2 (puisque le nombre d'intégrateurs est égal à 2).

Les deux réseaux sélecteurs de fréquence INT1 et INT2 sont ici des réseaux inductifs capacitifs respectivement accordés sur des fréquences situées dans la bande utile de signal, c'est-à-dire entre 1920 et 1980 MHz dans le cas présent.

Plus précisément, le réseau INT1 peut être accordé par exemple sur la fréquence de 1940 MHz tandis que le réseau INT2 peut être accordé sur la fréquence de 1960 MHz.

D'une façon générale, les fréquences de résonance des différents réseaux sélecteurs de fréquences fixent les zéros de la fonction de transfert du bruit, c'est-à-dire les fréquences auxquelles on élimine le bruit de quantification.

Les deux zéros de la fonction de transfert de bruit, correspondant aux deux fréquences de résonance des réseaux INT1 et INT2 ont pour but de satisfaire aux exigences du rapport signal/bruit dans la bande utile de transmission du signal.

Les pôles de la fonction de transfert sont fixés par les gains de retour continus k1et k2 et sont placés de façon à stabiliser l'ensemble du système.

Par ailleurs le mode de réalisation de la figure 2 donne un degré de liberté supplémentaire pour fixer les zéros de la fonction de transfert du signal.

En effet, comme indiqué ci-avant, les zéros et les pôles de la fonction de transfert du bruit sont fixés par les fréquences des réseaux sélecteurs de fréquences ainsi que par les gains de retour k1et k2. Par ailleurs, les pôles de la fonction de transfert du signal sont identiques aux pôles de la fonction de transfert du bruit.

Si l'on ne prévoit pas au moins deux gains de signal disposés entre la borne d'entrée BE et l'entrée du moyen de quantification QTZ (directement ou indirectement par l'intermédiaire des réseaux sélecteurs de fréquence) alors les zéros de la fonction de transfert du signal seraient automatiquement fixés, une fois fixés les gains de retour ainsi que les fréquences d'accord des réseaux sélecteurs de fréquence.

Mais, en présence d'au moins deux gains de signal, on peut alors ajuster la localisation des zéros de la fonction de transfert de signal, en jouant sur les valeurs relatives des gains de signal k8 à k10.

Ceci permet d'introduire un filtrage du signal d'entrée SG en dehors de la bande utile.

En effet une localisation des zéros de la fonction de transfert de signal à l'extérieur de la bande utile (à partir des valeurs relatives des gains de signal) permet d'assurer un filtrage du signal d'entrée SG et d'éliminer du bruit parasite à des fréquences prédéterminées situées en dehors de la bande utile. On peut ainsi relâcher la contrainte de filtrage sur les éléments de la chaîne d'émission situés en amont du dispositif d'amplification de puissance.

Par ailleurs, en jouant sur la valeur absolue des gains de signal on peut ajuster le gain de l'amplificateur, en particulier dans la bande de transmission utile, et ce sans dégrader le rapport signal/bruit.

Par ailleurs, puisque ces gains de signal n'agissent que sur le signal d'entrée, on réduit ainsi la dynamique d'entrée des moyens d'amplification de puissance.

Ces gains de signal peuvent être éventuellement programmables.

Par ailleurs, la présence de tels gains de signal permet de réduire la puissance de sortie du mélangeur disposé en amont du dispositif d'amplification de puissance. Ainsi, 15 dB de gain sur le signal permet une diminution de 15 dB de la puissance maximale nécessaire en sortie du mélangeur.

Enfin, ainsi, les exigences de linéarité du système sont les plus contraignantes sur les étages d'entrée des moyens d'amplification de puissance. Et, plus on se déplace vers les moyens de quantification, plus on relâche les contraintes sur les performances de linéarité des blocs intermédiaires, c'est à dire sur blocs correspondant aux gains k9 et k10.

## Revendications

1. Dispositif d'amplification de puissance ayant une fonction de transfert de signal et comportant une entrée pour recevoir un signal ayant une bande fréquentielle utile, et des moyens d'amplification de puissance du type delta-sigma, les moyens d'amplification de puissance du type delta-sigma (MAP) présentant un ordre global supérieur ou égal à un, et le dispositif comportant au moins deux amplificateurs de signal (k8-k10) connectés entre ladite entrée (BE) et les moyens d'amplification de puissance (MAP), **caractérisé par le fait que** les valeurs relatives de ces gains de signal sont ajustées de façon à localiser les zéros de la fonction de transfert de signal en dehors de ladite bande fréquentielle utile.

2. Dispositif selon la revendication 1, **caractérisé par le fait qu'**il comporte un nombre d'amplificateurs de signal égal à l'ordre global des moyens d'amplification de puissance (MAP), augmenté d'une unité.

3. Dispositif selon la revendication 1 ou 2, **caractérisé par le fait que** les amplificateurs de signal sont à gain programmable.

4. Dispositif selon la revendication 1, 2 ou 3, **caractérisé par le fait que** les moyens d'amplification de puissance (MAP) comportent au moins un réseau sélecteur de fréquence (INT1, INT2) accordé sur une fréquence située dans la bande utile

5. Dispositif selon l'une des revendications précédentes, **caractérisé par le fait qu'**il est réalisé sous la forme d'un circuit intégré.

6. Composant d'un système de communication sans fil, **caractérisé par le fait qu'**il comporte un dispositif d'amplification de puissance selon l'une des revendications 1 à 5.

7. Composant selon la revendication 6, **caractérisé par le fait qu'**il forme un téléphone mobile cellulaire.

## Claims

1. Power amplification device having a signal transfer function and, comprising an input for receiving a signal having a useful frequency band, and power amplification means of the delta-sigma type, the power amplification means of the delta-sigma type (MAP) exhibiting a global order greater than or equal to one, and the device comprising at least two signal amplifiers (k8-k10) connected between the said input (BE) and the power amplification means (MAP), **characterized in that** the relative values of these signal gains are adjusted in such a way as to locate the zeros of the signal transfer function outside the said useful frequency band.

2. Device according to Claim 1, **characterized in that** it comprises a number of signal amplifiers equal to the global order, increased by one unit, of the power amplification means (MAP).

3. Device according to Claim 1 or 2, **characterized in that** the signal amplifiers have programmable gain.

4. Device according to Claim 1, 2 or 3, **characterized in that** the power amplification means (MAP) comprise at least one frequency selector network (INT1, INT2) tuned to a frequency situated in the useful band.

5. Device according to one of the preceding claims, **characterized in that** it is embodied in the form of an integrated circuit.

6. Component of a wireless communication system, **characterized in that** it comprises a power amplification device according to one of Claims 1 to 5.

7. Component according to Claim 6, **characterized in that** it forms a cellular mobile telephone.

## Patentansprüche

1. Vorrichtung zur Leistungsverstärkung mit einer Signalübertragungsfunktion, wobei die Vorrichtung einen Eingang zum Empfangen eines Signals mit einem Nutzfrequenzband und Leistungsverstärkungseinrichtungen des Delta-Sigma-Typs aufweist, wobei die Leistungsverstärkungseinrichtungen des Delta-Sigma-Typs (MAP) eine globale Größenordnung größer oder gleich eins aufweisen, und wobei die Vorrichtung mindestens zwei Signalverstärker (k8-k10) aufweist, die zwischen dem Eingang (BE) und den Leistungsverstärkungseinrichtungen (MAP) angeordnet sind, **dadurch gekennzeichnet, daß** die relativen Werte dieser Signalverstärkungen auf eine Weise angepaßt werden, daß die Nullstellen der Signalübertragungsfunktion außerhalb des Nutzfrequenzbands sind.

2. Vorrichtung nach Anspruch 1, **dadurch gekennzeichnet, daß** sie eine Anzahl von Signalverstärkern gleich der um eine Einheit erhöhten globalen Größenordnung der Leistungsverstärkungseinrichtungen (MAP) aufweist.

3. Vorrichtung nach Anspruch 1 oder 2, **dadurch gekennzeichnet, daß** die Signalverstärker eine programmierbare Verstärkung haben.

4. Vorrichtung nach Anspruch 1, 2 oder 3, **dadurch gekennzeichnet, daß** die Leistungsverstärkungseinrichtungen (MAP) mindestens einen Frequenznetzwähler (INT1, INT2) aufweisen, der auf eine im Nutzband gelegenen Frequenz abgestimmt ist.

5. Vorrichtung nach einem der vorstehenden Ansprüche, **dadurch gekennzeichnet, daß** sie als eine integrierte Schaltung ausgeführt ist.

6. Komponente eines drahtlosen Kommunikationssystems, **dadurch gekennzeichnet, daß** sie eine Leistungsverstärkungsvorrichtung nach einem der Ansprüche 1 bis 5 aufweist.

7. Komponente nach Anspruch 6, **dadurch gekennzeichnet, daß** sie ein zellulares Mobiltelefon bildet.
